# EUROPÄISCHE PATENTSCHRIFT

(11) **EP 0 769 209 B1**
(45) Veröffentlichungstag und Bekanntmachung des Hinweises auf die Patenterteilung: **15.10.2003**
(21) Anmeldenummer: 95924165.4
(22) Anmeldetag: 03.07.1995
(51) Int. Cl.: H01L 21/98, H01L 25/065

(54) **VERFAHREN ZUR HERSTELLUNG EINER DREIDIMENSIONALEN SCHALTUNGSANORDNUNG**
METHOD OF MANUFACTURING THREE-DIMENSIONAL CIRCUITS
PROCEDE DE PRODUCTION D'UNE CIRCUITERIE TRIDIMENSIONNELLE

(30) Priorität: 05.07.1994 DE 4423566
(43) Veröffentlichungstag der Anmeldung: 23.04.1997
(73) Patentinhaber: Infineon Technologies AG, 81669 München (DE)
(72) Erfinder: HÜBNER, Holger, D-85598 Baldham (DE)
(74) Vertreter: Kindermann, Peter, Dipl.-Ing.
(86) Internationale Anmeldenummer: DE9500857
(87) Internationale Veröffentlichungsnummer: WO96001497

(56) Entgegenhaltungen:
- EP-A- 0 238 089
- EP-A- 0 531 723
- GB-A- 1 304 591
- 1990 SYMP. VLSI TECHNOLOGY, 4. Juni 1990, HONOLULU Seiten 95 - 96 Y. HAYASHI ET AL. 'fabrication of three-dimensional ic using "cumulatively bonded ic" (cubic) technology' in der Anmeldung erwähnt

## Beschreibung

Es werden zunehmend Halbleiterschaltungen entworfen, in denen integrierte Schaltungen in mehreren Ebenen übereinander gestapelt und miteinander verbunden werden. Insbesondere werden dabei integrierte Schaltungen verschiedener Technologien kombiniert.

Insbesondere zur Erhöhung der Packungsdichte und Verkürzung der Verbindungswege werden derartige Stapel von verschiedenen integrierten Schaltungen in einem Chipgehäuse zusammengefaßt. Dabei werden die die integrierten Schaltungen enthaltenden Substrate, die aus unterschiedlichen Substratmaterialien bestehen können und/oder in unterschiedlichen Technologien gefertigt sein können, jeweils bis auf weniger als 10 µm dünn geschliffen und als Stapel, auch Stack genannt, angeordnet. In senkrechter Richtung werden durch die Substrate hindurch Kontakte gebildet. Ein solcher Bauelementstapel erscheint von außen betrachtet als neuer Halbleiterbaustein. Er kann in einem Standardgehäuse mit reduzierter Anschlußzahl realisiert werden, obgleich er eine gesteigerte Funktionalität aufweist.

Aus der Druckschrift EP A 0 531 723 ist ein Verfahren zur Herstellung einer dreidimensionalen Schaltungsanordnung bekannt, bei dem in einem ersten Substrat eine aktive Schicht zur Realisierung einer ersten Hauptfläche ausgebildet ist. Beim Zusammenfügen des ersten Substrats mit einem zweiten Substrat trifft hierbei die einer aktiven Schicht des zweiten Substrats entsprechende zweite Hauptfläche auf die Rückseite des ersten Substrats.

Aus der Druckschrift GB A 1 304 591 ist ein Verfahren bekannt, bei dem ein mit einem Trägerwafer verbundenes Substrat von der Rückseite her gedünnt und mit Kontakten versehen wird. Beim Aufbringen auf ein weiteres Substrat trifft wiederum die Rückseite des einen Substrats auf die Vorderseite des anderen Substrats.

Aus Y. Hayashi et al, Symp. on VLSI Techn. (1990), Seite 95 bis 96, ist bekannt, zum Aufbau einer dreidimensionalen Schaltung ein Substrat mit der eine integrierte Schaltung umfassenden Vorderseite auf eine stabilisierende Trägerplatte aufzukleben. Von der Rückseite her wird das Substrat anschließend auf weniger als 10 µm dünn geschliffen. In der Rückseite werden zur Kontaktierung in einem im Stapel benachbarten Substrat großflächige Vertiefungen erzeugt und mit einer Au/In-Legierung gefüllt. Das Substrat wird nun auf das benachbarte Substrat so gestapelt, daß die Rückseite des ersten Substrats der integrierte Schaltungen umfassenden Vorderseite des zweiten Substrats benachbart ist. In der Vorderseite des zweiten Substrates sind Wolframstifte angeordnet, die in die mit der Au/In-Legierung gefüllten Vertiefungen eintauchen, wodurch vertikale Kontakte zwischen den benachbarten Substraten realisiert werden. Zur mechanischen Verbindung der beiden Substrate wird eine Polyimidschicht als Klebeschicht verwendet.

Die stabilisierende Trägerplatte muß anschließend in einem teuren und riskanten Prozeß wieder entfernt werden.

Der Erfindung liegt das Problem zugrunde, ein Verfahren zur Herstellung einer dreidimensionalen Schaltungsanordnung anzugeben, bei dem das riskante Entfernen einer Trägerplatte vermieden wird.

Dieses Problem wird erfindungsgemäß gelöst durch ein Verfahren nach Anspruch 1. Weitere Ausgestaltungen der Erfindung gehen aus den Unteransprüchen hervor.

Der Begriff "Substrat" wird hier sowohl für Substratscheiben, die insbesondere aus Halbleitermaterial bestehen und mikroelektronische Schaltungsstrukturen und/oder optoelektronischen Komponenten und/oder Sensorkomponenten umfassen, als auch für vereinzelte Bauelemente, optoelektronische Komponenten, Sensorelemente oder ähnliches verwendet.

Der Begriff "Bauelement" wird sowohl für mikroelektronische Schaltungsstrukturen als auch für optoelektronische Komponenten, Sensorkomponenten oder ähnliches verwendet.

In der Halbleitertechnologie werden in einer Substratscheibe meist eine Vielzahl von Bauelementen gleichzeitig hergestellt. Diese Bauelemente werden dabei in einer Hauptfläche der Substratscheibe gebildet. Der überwiegende Volumenanteil der Substratscheibe bleibt dabei ungenutzt und dient lediglich der mechanischen Stabilisierung. Typische Tiefen von Bauelementen betragen 5 µm .

In dem erfindungsgemäßen Verfahren wird eine dreidimensionale Schaltungsanordnung so realisiert, daß mindestens zwei benachbarte Substrate so aufeinandergestapelt werden, daß die Bauelemente umfassenden Hauptflächen beider Substrate aufeinandertreffen. Die elektrische Verbindung zwischen den beiden Substraten wird direkt über Kontakte der jeweils zu verbindenden Bauelemente, die aufeinandertreffen, realisiert. In diesem Verfahren ist es daher nicht erforderlich, vor dem Zusammenfügen zum Stapel eines der Substrate zu dünnen. Damit entfällt auch das Erfordernis des Aufklebens einer stabilisierenden Trägerplatte auf eine Hauptfläche, die aktive Bauelemente umfaßt.

Beim Aufbau einer dreidimensionalen Schaltungsanordnung mit mehr als zwei Bauelementebenen muß eines der Substrate gedünnt werden und mit Rückseitenkontakten versehen werden. In dem erfindungsgemäßen Verfahren wirkt dabei das andere, fest mit dem zu dünnenden Substrat verbundene Substrat als stabilisierende Trägerplatte.

Zum Aufbau komplexerer dreidimensionaler Schaltungsanordnungen mit mehr als zwei Bauelementeebenen liegt es im Rahmen der Erfindung, den Stapel nach dem Dünnen und der Erzeugung von Rückseitenkontakten auf eine Bauelemente umfassende Hauptebene eines weiteren Substrates aufzubringen und fest damit zu verbinden.

Alternativ kann der erfindungsgemäß hergestellte Stapel aus zwei Substraten mit einem weiteren erfindungsgemäß hergestellten Stapel aus zwei Substraten zusammengefügt werden, wobei jeweils die gedünnten Hauptflächen der Stapel mit den Rückseitenkontakten aufeinandertreffen. Die vertikale elektrische Verbindung wird dabei über aufeinandertreffende Kontakte realisiert.

In dem erfindungsgemäßen Verfahren erfolgt die mechanische Verbindung zwischen benachbarten Substraten über eine Haftschicht. Als Haftschicht ist zum Beispiel eine Polyimidschicht geeignet, die so ausgestaltet wird, daß elektrisch zu verbindende Kontakte aufeinandertreffen.

Vorzugsweise wird die mechanische Verbindung zwischen benachbarten Substraten über Metallflächen realisiert, auf die als Haftschicht Lotmetall aufgebracht wird. Durch Erhitzen werden die Metallflächen dann mit der angrenzenden Hauptfläche des anderen Substrats verlötet.

Aufeinandertreffende Kontakte in den jeweiligen Substraten können dabei ebenfalls miteinander verlötet werden.

Ein großer Vorteil in der Verwendung der Metallflächen zur festen Verbindung benachbarter Substrate besteht darin, daß dadurch ein zusätzlicher Abtransport der wegen der erhöhten Packungsdichte in dreidimensionalen Schaltungsanordnungen verstärkt auftretenden Verlustwärme sichergestellt ist. Ferner können die Metallflächen so ausgebildet werden, daß sie als Leiterbahn zwischen Kontakten in den benachbarten Substraten einsetzbar sind, die nicht unmittelbar aufeinandertreffen. Auf diese Weise können vertikale Kontakte auch zwischen solchen Kontakten realisiert werden, die nicht unmittelbar aufeinandertreffen.

Durch entsprechende Auswahl der Materialien für die Metallflächen und das Lotmetall kann beim Löten eine Legierung erzielt werden, deren Schmelzpunkt höher ist als der Schmelzpunkt des Lotmetalls, als die Betriebstemperatur der dreidimensionalen Schaltungsanordnung und als Temperaturen, die beim weiteren Prozessieren der Schaltungsanordnung auftreten. Damit wird ein An- oder Auflösen der festen Verbindung bei weiteren Prozeßschritten vermieden. Es liegt im Rahmen der Erfindung, dabei für die Metallflächen Wolfram oder Nickel und für das Lotmetall Gallium oder Indium zu verwenden.

Im folgenden wird die Erfindung anhand der Ausführungsbeispiele und der Figuren näher erläutert.
- Figur 1: zeigt ein vereinzeltes Bauelement, das mit einer Substratscheibe verbunden ist.
- Figur 2: zeigt zwei Substratscheiben, die über Metallflächen miteinander verbunden sind.
- Figur 3: zeigt die beiden über Metallflächen miteinander verbundenen Substratscheiben nach dem Dünnschleifen der einen Substratscheibe.
- Figur 4: zeigt eine dreidimensionale Schaltungsanordnung mit drei Bauelementebenen.
- Figur 5: zeigt eine dreidimensionale Schaltungsanordnung mit vier Bauelementebenen.

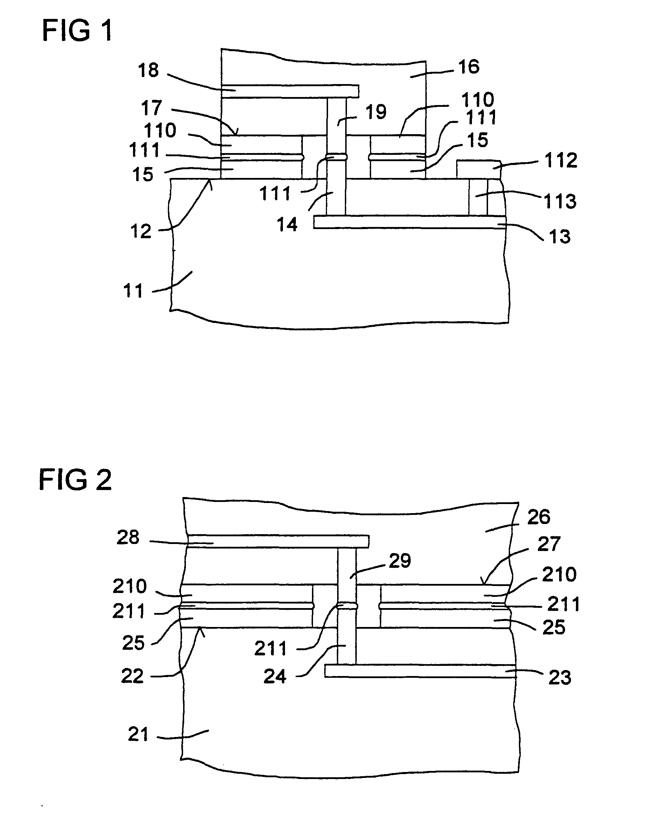

Ein erstes Substrat 11 (siehe Figur 1), das zum Beispiel eine Halbleiterscheibe aus einkristallinem Silizium oder ein III-V-Halbleiter ist, umfaßt Schaltungsstrukturen, die Bestandteil einer mikroelektronischen Schaltung oder einen optoelektronischen Komponente oder einer Sensorkomponente sind. Die Schaltungsstrukturen, die im einzelnen in Figur 1 nicht dargestellt sind, umfassen mindestens eine erste Metallisierungsebene 13, die durch isolierendes Material, zum Beispiel SiO₂, gegenüber dem ersten Substrat 11 isoliert ist (nicht dargestellt). Ein erster Kontakt 14 reicht von der ersten Hauptfläche 12 auf die erste Metallisierungsebene 13. Auf der ersten Hauptfläche 12 sind erste Metallflächen 15 aus zum Beispiel Wolfram angeordnet, die zum Beispiel durch ganzflächige CVD-Abscheidung und anschließende Strukturierung einer Wolframschicht gebildet werden.

Ein zweites Substrat 16, das zum Beispiel ein vereinzeltes Bauelement ist, umfaßt im Bereich einer zweiten Hauptfläche 17 Schaltungsstrukturen, die Bestandteile einer mikroelektronischen Schaltung oder einer optoelektronischen Komponente oder einer Sensorkomponente sind. Die Schaltungsstrukturen, die im einzlenen in Figur 1 nicht dargestellt sind, umfassen mindestens eine zweite Metallisierungsebene 18, die durch isolierendes Material, zum Beispiel SiO₂, gegenüber dem zweiten Substrat 16 isoliert ist (nicht dargestellt). Auf die zweite Metallisierungsebene 18 reicht ein zweiter Kontakt 19, der zur zweiten Hauptebene 17 führt. Auf der zweiten Hauptfläche sind zweite Metallflächen 110 angeordnet, die zum Beispiel durch ganzflächiges Sputtern und anschließende Strukturierung einer Nickelschicht gebildet werden.

Das erste Substrat 11 und das zweite Substrat 16 werden so zusammengefügt, daß die erste Hauptfläche 12 und die zweite Hauptfläche 17 aufeinandertreffen. Zwischen die ersten Metallflächen 15 und die zweiten Metallflächen 110 wird eine Lotmetallschicht 111 aufgebracht. Die Lotmetallschicht 111 wird auch auf den ersten Kontakt 14 und den zweiten Kontakt 19 aufgebracht.

Als Lotmetallschicht 111 wird zum Beispiel Gallium verwendet. Die Schichtdicke der Lotmetallschicht 111 wird vorzugsweise so abgestimmt, daß der Galliumanteil im Nickel nach dem Verlöten unter 25 Gewichtsprozent bleibt. Dann weist die beim Löten entstandene Legierung eine Schmelztemperatur von über 1200°C auf. Bei einer Dicke der Metallflächen im Bereich von 1 bis 2 µm, ist dieses bei einer Schichtdicke des Lotmetalls 111 von maximal 0,5 µm der Fall.

Die Anordnung wird auf etwa 100°C erhitzt, so daß die Lotmetallschicht 111 schmilzt und es zu einem Verlöten der ersten Metallflächen 15 mit den zweiten Metallflächen 110 kommt.

Da das erste Substrat 11 eine Halbleiterscheibe, das zweite Substrat 16 jedoch ein vereinzeltes Bauelement ist, kann auf der ersten Hauptfläche 12 des ersten Substrats 11 ein Anschluß 112 auf die erste Metallisierungsebene 13 hergestellt werden. Dazu wird in der ersten Hauptfläche 12 ein Kontaktloch geöffnet und mit einem Anschlußkontakt 113 versehen.

Nach dem Zusammenfügen und Verbinden der beiden Substrate 11, 16 wird das zweite Substrat 16 an einer der zweiten Hauptfläche 17 gegenüberliegenden Hauptfläche gedünnt (nicht dargestellt). Das erste Substrat 11 wirkt dabei als stabilisierende Trägerplatte.

Es ist vorteilhaft, vor dem Zusammenfügen des ersten Substrats 11 und des zweiten Substrats 16 jeweils die Schaltungsstrukturen in den Substraten 11, 16 zu testen und jeweils funktionierende Schaltungsstrukturen zusammenzufügen. Dadurch wird die effekte Ausbeute bei der Herstellung der dreidimensional integrierten Schaltungsanordnung vergrößert.

Ein erstes Substrat 21 (siehe Figur 2), das zum Beispiel eine Halbleiterscheibe aus einkristallinem Silizium oder ein III-V-Halbleiter ist, umfaßt im Bereich einer ersten Hauptfläche 22 Schaltungsstrukturen, die Bestandteil einer mikroelektronischen Schaltung oder einer optoelektronischen Komponente oder einer Sensorkomponente sind. Die Schaltungsstrukturen, die im einzelnen in Figur 2 nicht dargestellt sind, umfassen mindestens eine erste Metallisierungsebene 23, die durch isolierendes Material, zum Beispiel SiO₂ (nicht dargestellt) gegenüber dem ersten Substrat 21 isoliert ist. Auf die erste Metallisierungsebene 23 reicht von der ersten Hauptfläche 22 her ein erster Kontakt 24. Auf der ersten Hauptfläche 22 sind erste Metallflächen 25 angeordnet, die zum Beispiel durch ganzflächige CVD-Abscheidung von Wolfram und anschließende Strukturierung gebildet werden, angeordnet.

Ein zweites Substrat 26, das zum Beispiel eine Halbleiterscheibe aus einkristallinem Silizium oder ein III-V-Halbleiter ist, umfaßt den Bereich einer zweiten Hauptfläche 27 Schaltungsstrukturen, die Bestandteil einer mikroelektronischen Schaltung oder einer optoelektronischen Komponente oder einer Sensorkomponente sind. Die Schaltungsstrukturen, die im einzelnen in Figur 2 nicht dargestellt sind, umfassen mindestens eine zweite Metallisierungsebene 28, die durch isolierendes Material, zum Beispiel SiO₂ (nicht dargestellt) gegenüber dem zweiten Substrat 26 isoliert ist. Von der zweiten Hauptfläche 27 reicht ein zweiter Kontakt 29 auf die zweite Metallisierungsebene 28. Auf der zweiten Hauptfläche 27 sind Metallflächen 210 angeordnet, die zum Beispiel durch CVD-Abscheidung und anschließende Strukturierung einer Nickelschicht gebildet werden.

Das erste Substrat 21 und das zweite Substrat 26 werden so zusammengefügt, daß die ersten Metallisierungsflächen 25 auf die zweiten Metallisierungsflächen 210 treffen und daß der erste Kontakt 24 auf den zweiten Kontakt 29 trifft. Zwischen die Metallflächen 25, 210 und die Kontakte 24, 29 wird eine Lotmetallschicht 211, zum Beispiel aus Gallium oder Indium, aufgebracht. Die Schichtdicken werden so aufeinander abgestimmt, wie anhand von Figur 1 geschildert. Durch Erhitzen der Anordnung auf etwa 200°C werden die Metallflächen 25, 210 und die Kontakte 24, 29 miteinander verlötet. Über die Kontakte 24, 29 kommt es zu einer elektrischen Verbindung zwischen den Schaltungsstrukturen im ersten Substrat 21 und zweiten Substrat 26, über die verlöteten Metallflächen 25, 210 kommt es zu einer festen mechanischen Verbindung zwischen beiden Substraten. Die Metallflächen 25, 210 stellen zugleich den Abtransport der wegen der hohen Packungsdichte beträchtlichen Verlustwärme sicher.

Ehe dem aus dem ersten Substrat 21 und dem zweiten Substrat 26 gebildeten Stapel weitere Bauelementebenen hinzugefügt werden können, muß eines der Substrate 21, 26 gedünnt werden.

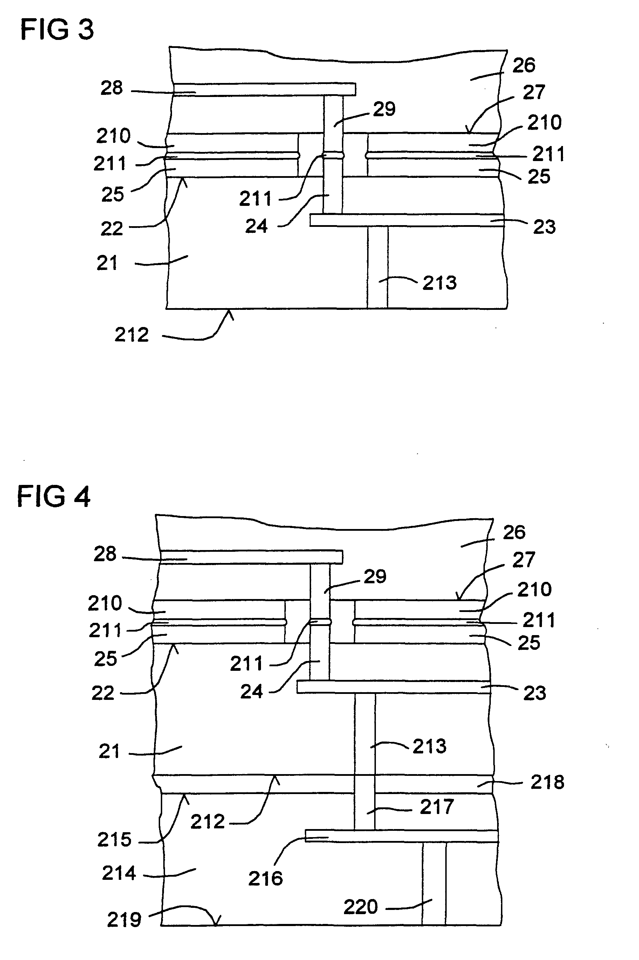

Dazu wird das erste Substrat 21 an der der ersten Hauptfläche 22 gegenüberliegenden Rückseite 212 dünn geschliffen, bis die Dicke des ersten Substrats 5 bis 20 µm, vorzugsweise 10 µm beträgt (siehe Figur 3). Beim Dünnschleifen wirkt das zweite Substrat 26 als stabilisierende Trägerplatte.

Von der Rückseite 212 her wird ein Rückseitenkontakt 213 auf die erste Metallisierungsebene 23 gebildet. Dazu wird ein Kontaktloch geätzt, das mit einer Metallisierung, zum Beispiel aus Wolfram, aufgefüllt wird.

Der aus dem ersten Substrat 21 und dem zweiten Substrat 26 gebildete Stapel wird anschließend mit einem dritten Substrat 214 zusammengefügt (siehe Figur 4). Das dritte Substrat 214, das zum Beispiel eine Halbleiterscheibe aus einkristallinem Silizium oder ein III-V-Halbleiter ist, umfaßt Schaltungsstrukturen, die Bestandteil einer mikroelektronischen Schaltung oder einer optoelektronischen Komponente oder einer Sensorkomponente sind. Die Schaltungsstrukturen, die im einzelnen in Figur 4 nicht dargestellt sind, umfassen mindestens eine dritte Metallisierungsebene 216, die durch isolierendes Material, zum Beispiel SiO₂ (nicht dargestellt) gegenüber dem dritten Substrat 214 isoliert ist. Von der dritten Hauptfläche 215 reicht ein dritter Kontakt 217 auf die dritte Metallisierungsebene 216.

Das dritte Substrat 214 wird mit dem aus erstem Substrat 21 und zweitem Substrat 26 gebildeten Stapel so zusammengefügt, daß die dritte Hauptebene 215 auf die Rückseite 212 des ersten Substrats 21 trifft. Dabei trifft der dritte Kontakt 217 auf den Rückseitenkontakt 213 des ersten Substrats 21. Außerhalb des dritten Kontakts 217 und des Rückseitenkontaktes 213 wird eine Haftschicht 218 zum Beispiel aus Polyimid aufgebracht, über die das dritte Substrat 214 fest mit dem ersten Substrat 21 verbunden wird. Der dritte Kontakt 217 und der Rückseitenkontakt 213 sind durch direktes Aufeinandertreffen der Kontakte elektrisch miteinander verbunden.

Das dritte Substrat 214 wird von einer der dritten Hauptfläche 215 gegenüberliegenden Rückseite 219 her auf 5 bis 20 µm, vorzugsweise 10 µm, dünn geschliffen. Dabei wirkt wiederum das zweite Substrat 26 als stabilisierende Trägerplatte. Anschließend wird ein Rückseitenkontakt 220 von der Rückseite 219 auf die dritte Metallisierungsebene 216 gebildet. Der Rückseitenkontakt 220 kann als Anschluß zu der dreidimensionalen Schaltungsanordnung verwendet werden oder als vertikaler Kontakt zu einer weiteren hinzuzufügenden Bauelementebene.

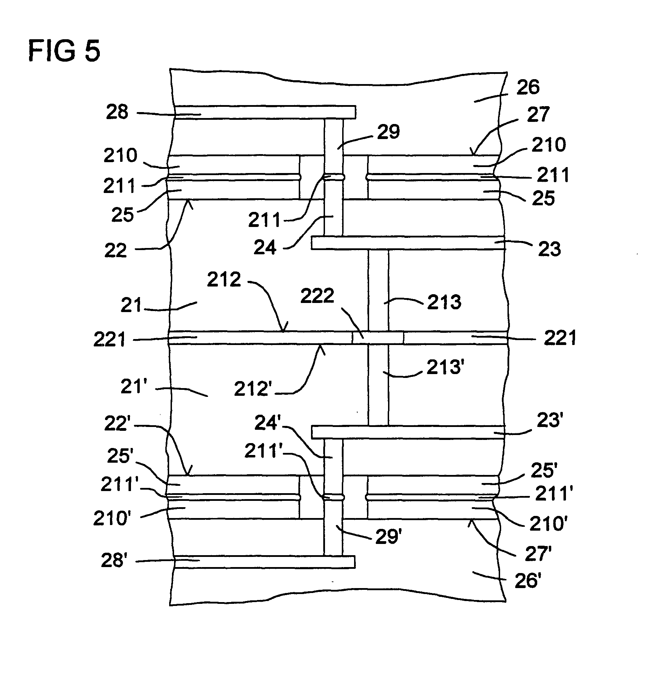

Statt mit dem dritten Substrat 214 kann der aus dem ersten Substrat 22 und dem zweiten Substrat 26 gebildete Stapel mit einem zweiten Stapel fest verbunden werden (siehe Figur 5), der ein erstes Substrat 21' mit einer ersten Metallisierungsebene 23' einer ersten Hauptfläche 22', einem ersten Kontakt 24' und ersten Metallflächen 25' sowie ein zweites Substrat 26' mit einer zweiten Hauptebene 27', einer zweiten Metallisierungsebene 28', einem zweiten Kontakt 29' und zweiten Metallflächen 210' umfaßt. Dabei sind das erste Substrat 21' und das zweite Substrat 26' analog dem ersten Substrat 21 und dem zweiten Substrat 26 aufgebaut. Nach dem erfindungsgemäßen Verfahren wie es anhand von Figur 2 für das erste Substrat 21 und das zweite Substrat 26 erläutert wurde, sind das erste Substrat 21' und das zweite Substrat 26' über eine Lotmetallschicht 211' fest miteinander verbunden. Desgleichen sind die Kontakte 24' und 29' über die Lotmetallschicht 211' fest und elektrisch miteinander verbunden.

Das erste Substrat 21' wird von einer der ersten Hauptfläche 22' gegenüberliegenden Rückseite 212' her dünngeschliffen, wie anhand von Figur 3 in Bezug auf das erste Substrat 21 erläutert. Anschließend wird ein Rückseitenkontakt 213' von der Rückseite 212' auf die erste Metallisierungsebene 22' erzeugt. Die beiden im wesentlichen identischen Stapel 21, 26 und 21', 26' werden nun über eine Haftschicht 221 aus zum Beispiel Polyimid fest miteinander verbunden. Dabei treffen die Rückseiten 212 und 212' sowie die Rückseitenkontakte 213, 213' aufeinander. Die elektrische Verbindung zwischen den Rückseitenkontakten 213, 213' wird zum Beispiel durch eine dazwischen angeordnete Metallfläche 222 aus zum Beispiel Lotmetall realisiert. Alternativ können die Stapel 21, 26 und 21', 26' auch über Metallflächen und Lotmetall miteinander verbunden werden.

Ausgehend von dem anhand von Figur 5 beschriebenen Stapel, der vier Substratscheiben umfaßt, kann durch sukzessives Ausführen der anhand von Figur 3 und Figur 4 oder 5 beschriebenen Prozeßschritte eine dreidimensionale Schaltungsanordnung noch mit beliebig vielen Bauelementebenen realisiert werden.

Wesentlich für das erfindungsgemäße Verfahren ist, daß keinerlei zusätzliche, aufgeklebte Trägerplatte für die Dünnschleifprozesse erforderlich ist, da in dem erfindungsgemäßen Verfahren die Substrate in ihrer vollen Dicke zusammengefügt werden. In der Siliziumprozeßtechnik weisen Substratscheiben Dicken von etwa 650 µm auf.

Da die zusammenzufügenden Substrate nicht gedünnt werden, ist eine Justierung über die Rückseite der Substrate nicht möglich. Die zusammenzufügenden Hauptflächen der Substrate müssen jedoch so aufeinander justiert werden, daß entsprechende Kontakte oder Metallflächen aufeinandertreffen. Dazu wird vorzugsweise ein Split-Field-Mikroskop verwendet. In einem solchen Split-Field-Mikroskop werden die zueinander zu justierenden Substrate in einer hochpräzisen Mechanik in einem Abstand von etwa 15 cm angeordnet. Zwischen die beiden Substrate wird ein Prisma eingeführt, über das Bilder beider Substatoberflächen erzeugt werden. Diese Substratoberflächen werden nun so zueinander justiert, daß die Bilder zur Deckung kommen. Nach Beendigung des Justiervorganges wird das Prisma herausgefahren und die Substrate über die Präzisionsmechanik zusammengefahren. Das erfindungsgemäße Verfahren wurde mit einem Split-Field-Mikroskop erprobt, das kommerziell erhältlich ist. Das verwendete Split-Field-Mikroskop der Firma Süß, Garching, ermöglicht die Justierung von Substratscheiben mit einer Justiergenauigkeit von 3 µm.

## Patentansprüche

1. Verfahren zur Herstellung einer dreidimensionalen Schaltungsanordnung,
- bei dem in einer ersten Hauptfläche (12) eines ersten Substrats (11) mindestens ein erstes Bauelement mit ersten Kontakten (14) gebildet wird, wobei die ersten Kontakte (14) im Bereich der ersten Hauptfläche (12) angeordnet sind,
- bei dem in einer zweiten Hauptfläche (17) eines zweiten Substrats (16) mindestens ein zweites Bauelement mit zweiten Kontakten (19) gebildet wird, wobei die zweiten Kontakte (19) im Bereich der zweiten Hauptfläche (17) angeordnet sind,
- bei dem nachfolgend das erste Substrat (11) und das zweite Substrat (16) so zu einem Stapel zusammengefügt werden, daß die erste Hauptfläche (12) auf die zweite Hauptfläche (17) trifft und daß mindestens ein erster Kontakt (14) und ein zweiter Kontakt (19) aufeinandertreffen,
- bei dem mindestens eine der Hauptflächen (12, 17) mit einer Haftschicht (111) versehen wird, über die das erste Substrat (11) und das zweite Substrat (16) fest miteinander verbunden werden,
- bei dem mindestens eines der Substrate (11) mit elektrischen Anschlüssen (112) versehen wird,
- bei dem das erste Substrat (21) von einer der ersten Hauptfläche (12) gegenüberliegenden Rückseite (212) her gedünnt wird, wobei das zweite Substrat (26) als stabilisierende Trägerplatte wirkt,
- bei dem nachfolgend in der Rückseite (212) Kontaktlöcher zu dem ersten Bauelement geöffnet und mit Rückseitenkontakten (213) versehen werden.

2. Verfahren nach Anspruch 1,
- bei dem auf mindestens eine der Hauptflächen (12) Metallflächen (15) aufgebracht werden,
- bei dem als Haftschicht (111) auf die Metallflächen (15) Lotmetall aufgebracht wird,
- bei dem die Metallflächen (15) durch Erhitzen mit der angrenzenden Hauptfläche (17) des anderen Substrats (16) verlötet werden.

3. Verfahren nach Anspruch 2,
bei dem für die Metallflächen Wolfram oder Nickel und für das Lotmetall Gallium oder Indium verwendet wird.

4. Verfahren nach Anspruch 2,
- bei dem zusätzliche Metallflächen (110), die jeweils an eine der erstgenannten Metallflächen (15) angrenzen, auf die Hauptfläche (17) des jeweils anderen Substrats (16) aufgebracht werden,
- bei dem die erstgenannten Metallfächen (15) mit den angrenzenden zusätzlichen Metallflächen (110) verlötet werden.

5. Verfahren nach einem der Ansprüche 2 bis 4,
bei dem zur elektrischen Verbindung von Kontakten im ersten Substrat und im zweiten Substrat, die im Bereich der aneinandergrenzenden Hauptflächen nicht aufeinandertreffen, mindestens eine Metallfläche so gebildet wird, daß sie eine Leiterbahn zwischen den beiden Kontakten bildet.

6. Verfahren nach einem der Ansprüche 1 bis 5,
- bei dem nach der Erzeugung der Rückseitenkontakte der Stapel aus erstem Substrat (21) und zweitem Substrat (26) so mit einem dritten Substrat zusammengefügt wird, das im Bereich einer dritten Hauptfläche mindestens ein drittes Bauelement mit dritten Kontakten (217) aufweist, daß die dritte Hauptfläche (215) auf die Rückseite (212) trifft und daß mindestens der dritte Kontakt (217) auf den Rückseitenkontakt (213) trifft,
- bei dem mindestens die Rückseite oder die dritte Hauptfläche (215) mit einer Haftschicht (218) versehen wird, über die das dritte Substrat (214) mit dem Stapel (21, 26) fest verbunden wird.

7. Verfahren nach einem der Ansprüche 1 bis 5,
- bei dem der Stapel aus erstem Substrat (21) und zweitem Substrat (26) mit einem identischen Stapel aus erstem Substrat (21') und zweitem Substrat (26') so zusammengefügt wird, daß die Rückseiten (212, 212') aufeinandertreffen und daß zwischen den Rückseitenkontakten (213, 213') eine elektrische Verbindung entsteht,
- bei dem mindestens auf eine der Rückseiten (212, 212') eine Haftschicht (221) aufgebracht wird, über die die beiden Stapel (21, 26; 21', 26') fest miteinander verbunden sind.

## Claims

1. Method for production of a three-dimensional circuit arrangement,
- in which at least one first component with first contacts (14) is formed in a first main surface (12) of a first substrate (11), with the first contacts (14) being arranged in the region of the first main surface (12),
- in which at least one second component with second contacts (19) is formed in a second main surface (17) of a second substrate (16), with the second contacts (19) being arranged in the region of the second main surface (17),
- in which the first substrate (11) and the second substrate (16) are then joined together to form a stack such that the first main surface (12) touches the second main surface (17), and such that at least one first contact (14) and one second contact (19) touch one another,
- in which at least one of the main surfaces (12, 17) is provided with an adhesive layer (111) via which the first substrate (11) and the second substrate (16) are firmly connected to one another,
- in which at least one of the substrates (11) is provided with electrical connections (112),
- in which the first substrate (21) is thinned from a rear side (212) opposite the first main surface (12), with the second substrate (26) acting as a stabilizing supporting plate,
- in which contact holes to the first component are then opened in the rear side (212) and are provided with rear side contacts (213).

2. The method as claimed in Claim 1,
- in which metal surfaces (15) are applied to at least one of the main surfaces (12),
- in which solder metal is applied as the adhesive layer (111) to the metal surfaces (15),
- in which the metal surfaces (15) are soldered by heating to the adjacent main surface (17) of the other substrate (16).

3. The method as claimed in Claim 2,
in which tungsten or nickel is used for the metal surfaces and gallium or indium is used for the solder metal.

4. The method as claimed in Claim 2,
- in which additional metal surfaces (110) which are in each case adjacent to one of the first-mentioned metal surfaces (15), are applied to the main surface (17) of the respectively other substrate (16),
- in which the first-mentioned metal surfaces (15) are soldered to the adjacent additional metal surfaces (110).

5. The method as claimed in one of Claims 2 to 4,
in which at least one metal surface is formed for electrical connection of contacts in the first substrate and in the second substrate, which do not touch one another in the region of the main surfaces which are adjacent to one another, such that said metal surface forms a conductor track between the two contacts.

6. The method as claimed in one of Claims 1 to 5,
- in which, after the production of the rear-side contacts, the stack comprising the first substrate (21) and the second substrate (26) is joined together with a third substrate which, in the region of a third main surface, has at least one third component having third contacts (217), such that the third main surface (215) touches the rear side (212) and such that at least the third contact (217) touches the rear-side contact (213),
- in which at least the rear side or the third main surface (215) is provided with an adhesive layer (218) via which the third substrate (214) is firmly connected to the stack (21, 26).

7. The method as claimed in one of Claims 1 to 5,
- in which the stack comprising the first substrate (21) and the second substrate (26) is joined together with an identical stack comprising the first substrate (21') and the second substrate (26') such that the rear sides (212, 212') touch one another and such that an electrical connection is produced between the rear-side contacts (213, 213'), -in which an adhesive layer (221) is applied at least to one of the rear sides (212, 212'), via which adhesive layer (221) the two stacks (21, 26; 21', 26') are firmly connected to one another.

## Revendications

1. Procédé de production d'une circuiterie tridimensionnelle,
- dans lequel on forme dans une première surface (12) principale d'un premier substrat (11) au moins un premier composant ayant des premiers contacts (14), les premiers contacts (14) étant disposés dans la zone de la première surface (12) principale,
- dans lequel on forme dans une deuxième surface (17) principale d'un deuxième substrat (16) au moins un deuxième composant ayant des deuxièmes contacts (19), les deuxièmes contacts (19) étant disposés dans la zone de la deuxième surface (17) principale,
- dans lequel on assemble ensuite le premier substrat (11) et le deuxième substrat (16) en une pile, de sorte que la première surface (12) principale et la deuxième surface (17) principale se rencontrent et que au moins un premier contact (14) et un deuxième contact (19) viennent l'un sur l'autre,
- dans lequel on munit au moins l'une des surfaces (12, 17) principales d'une couche (111) adhésive par laquelle le premier substrat (11) et le deuxième substrat (16) sont reliés solidement entre eux,
- dans lequel on munit au moins l'un des substrats (11) de bornes (112) électriques,
- dans lequel on amincit le premier substrat (21) à partir d'une face (212) arrière opposée à la première surface (12) principale, le deuxième substrat (26) servant de plaque-support de stabilisation,
- dans lequel on ouvre ensuite dans la face (212) arrière des trous de métallisation allant vers le premier composant et on les munit de contacts (213) de face arrière.

2. Procédé suivant la revendication 1,
- dans lequel on dépose sur au moins l'une des surfaces (12) principales des surfaces (15) métalliques,
- dans lequel on dépose comme couche (111) adhésive sur les surfaces (15) métalliques du métal de brasure,
- dans lequel on brase les surfaces (15) métalliques par chauffage à la surface (17) principale adjacente de l'autre substrat (16).

3. Procédé suivant la revendication 2,
dans lequel on utilise pour les surfaces métallique du tungstène ou du nickel et pour le métal de brasure du gallium ou de l'indium.

4. Procédé suivant la revendication 2,
- dans lequel on dépose des surfaces (110) métalliques supplémentaires qui sont adjacentes respectivement à l'une des surfaces (15) métalliques mentionnées en premier sur la surface (17) principale de l'autre substrat (16) respectif,
- dans lequel on brase les surfaces (15) métalliques mentionnées en premier avec les surfaces (110) métalliques supplémentaires adjacentes.

5. Procédé suivant l'une des revendications 2 à 4,
dans lequel, pour la liaison électrique de contact du premier substrat et du deuxième substrat, qui ne sont pas les uns sur les autres dans la zone des surfaces principales adjacentes, on forme au moins une surface métallique, de façon à ce qu'elle forme une piste conductrice entre les deux contacts.

6. Procédé suivant l'une des revendications 1 à 5,
- dans lequel, après la production des contacts de face arrière, on assemble la pile constituée du premier substrat (21) et du deuxième substrat (26) avec un troisième substrat qui a, dans la zone d'une troisième surface principale, au moins un troisième composant ayant des troisièmes contacts (217), de façon à ce que la troisième surface (215) principale s'applique à la face (212) arrière et de façon à ce qu'au moins le troisième contact (217) vienne sur le contact (213) de face arrière,
- dans lequel on munit au moins la face arrière ou la troisième surface (215) principale d'une couche (218) adhésive par laquelle le troisième substrat (214) est relié solidement à la pile (21, 26).

7. Procédé suivant l'une des revendications 1 à 5,
- dans lequel on réunit la pile constituée du premier substrat (21) et du deuxième substrat (26) à une pile identique constituée d'un premier substrat (21') et d'un deuxième substrat (26') de façon à ce que les faces (212, 212') arrière viennent l'une sur l'autre et de façon à créer une liaison électrique entre les contacts (213, 213') de face arrière,
- dans lequel on dépose au moins sur l'une des faces (212, 212') arrière une couche (221) adhésive par laquelle les deux piles (21, 26 ; 21', 26') sont reliées solidement entre elles.
